# FASCICULE DE BREVET EUROPEEN

(11) **EP 2 160 933 B1**
(45) Date de publication et mention de la délivrance du brevet: **26.08.2015**
(21) Numéro de dépôt: 08760911.1
(22) Date de dépôt: 12.06.2008
(51) Int. Cl.: H05K 5/00, H05K 5/02

(54) **BOÎTIER CONSTITUÉ DE COQUILLES ASSEMBLÉES ENTRE ELLES POUR LA PROTECTION D'UN DISPOSITIF ÉLECTRONIQUE.**
AUS ZUSAMMENGEBAUTEN SCHALEN BESTEHENDES GEHÄUSE ZUM SCHUTZ EINER ELEKTRONISCHEN EINRICHTUNG
HOUSING CONSISTING OF SHELLS ASSEMBLED TOGETHER TO PROTECT AN ELECTRONIC DEVICE

(30) Priorité: 12.06.2007 FR 0704172
(43) Date de publication de la demande: 10.03.2010
(73) Titulaire: Valeo Systèmes Thermiques, 78321 Le Mesnil St Denis Cedex (FR)
(72) Inventeur: BERAUD, Henry, F-94300 Vincennes (FR); CORDUAN, Patrick, F-77390 Guignes (FR); CUNY, Bernard, F-91370 Verrières Le Buisson (FR)
(74) Mandataire: Benoit, Monique
(86) Numéro de dépôt international: PCT/EP2008/057368
(87) Numéro de publication internationale: WO 2008/155283

(56) Documents cités:
- EP-A- 1 179 453
- WO-A-00/76283
- US-A- 3 629 901
- US-A- 4 703 160
- US-A- 5 541 813

## Description

### Domaine technique de l'invention.

La présente invention est du domaine des boîtiers de protection d'un dispositif électronique destiné à équiper un véhicule automobile. Elle a pour objet un tel boîtier constitué de coquilles assemblées entre elles.

### Etat de la technique.

Un véhicule automobile est couramment équipé d'une installation de ventilation, de chauffage et/ou de climatisation dont la mise en oeuvre est commandée par une carte électronique. Cette dernière est pourvue de connecteurs permettant au moins une liaison électrique avec des équipements constitutifs de l'installation, tels qu'un ventilateur ou analogue.

La carte électronique est logée à l'intérieur d'un boîtier de protection qui est constitué à partir de l'assemblage de coquilles entre elles, telles que par exemple une façade avant et un capot arrière de fermeture. Les coquilles sont chacune réalisées à partir d'une opération de moulage d'une matière plastique rigide qui est souhaitée la plus économique possible, telle que le polypropylène, éventuellement chargé en talc, ou tout autre matériau plastique analogue susceptible de variations linéaires de longueur.

Lors de l'opération d'assemblage du boîtier de protection, la carte électronique est positionnée précisément par rapport à une première coquille, façade avant notamment, et est maintenue ou fixée à cette dernière par clipage ou par des moyens d'assemblage analogue. Une deuxième coquille est fixée également par clipage ou par des moyens d'assemblage analogue sur la première coquille et/ou la carte électronique pour confiner cette dernière à l'intérieur du boîtier de protection. Pour permettre une liaison électrique entre la carte électronique logée dans le boîtier de protection et les équipements, la deuxième coquille comporte des fenêtres pour le passage des connecteurs.

Se pose le problème général de l'assemblage des coquilles entre elles qui est souhaité simple, rapide et néanmoins robuste. De plus, l'assemblage des coquilles entre elles ne doit pas induire d'altérations de la carte électronique et plus particulièrement des connecteurs reçus par les fenêtres ménagées à travers la deuxième coquille. La réception des connecteurs par les fenêtres étant obtenue à partir d'un emboîtement en contact étroit des connecteurs à l'intérieur des fenêtres, l'assemblage des coquilles entre elles est délicat et peut induire un rebut conséquent par déformation de ces dernières, qu'il est souhaitable de minimiser.

Plus particulièrement, un premier problème posé réside dans le fait que, les connecteurs tendant à être de dimension de plus en plus petite, typiquement de l'ordre de 0,6 mm x 0,6 mm, le maintien de ces connecteurs à l'intérieur des fenêtres nécessite un alignement d'autant plus précis des connecteurs en vis-à-vis des fenêtres.

Un deuxième problème posé réside dans le fait qu'il est difficile et/ou onéreux d'obtenir en série des coquilles dont les dimensions respectives sont rigoureusement identiques. Plus particulièrement, les dimensions des fenêtres et/ou leur positionnement respectif sont susceptibles de varier de manière importante par rapport à des valeurs de consigne, cette variation étant d'autant plus importante que les connecteurs sont distants les uns des autres. De telles variations entraînent soit une impossibilité de rapporter la deuxième coquille sur la première coquille et/ou la carte électronique, soit un déchaussement, voire une détérioration, des connecteurs lors de la mise en place de la deuxième coquille sur la première coquille. De plus, les cartes électroniques couramment utilisées étant munies de connecteurs dont les dimensions tendent à être de plus en plus faibles, il en découle une fragilité accrue de ces connecteurs, ce qui augmente le risque de déchaussement, voire de détérioration des connecteurs.

Un troisième problème posé réside dans le fait que la deuxième coquille et la carte électronique sont réalisées à partir de matériaux dont les coefficients respectifs de dilatation thermique sont susceptibles d'être différents. Par exemple, la carte électronique est réalisée à partir d'une résine époxy chargée de fibres de verre dont le coefficient de dilatation thermique est inférieur à celui du polypropylène chargé en talc constitutif de la deuxième coquille. Or le boîtier est fréquemment placé dans un environnement soumis à des variations importantes de température, par exemple provoquées par des rayonnements solaires. Il en résulte des efforts antagonistes conséquents entre la deuxième coquille et les connecteurs qui sont susceptibles de provoquer une détérioration de ces derniers.

Un quatrième problème posé réside dans le fait que le boîtier de protection est fréquemment soumis à des vibrations qui sont susceptibles d'affecter la réception des connecteurs par les fenêtres.

### Objet de l'invention.

Le but de la présente invention est de proposer un boîtier de protection d'un dispositif électronique réalisé à partir de l'assemblage de coquilles entres elles, l'assemblage des coquilles entre elles étant robuste, aisé et rapide à mettre en oeuvre, et/ou lors de variations thermiques conséquentes de l'environnement dans lequel est placé le boîtier de protection, et/ou encore lorsque le boîtier de protection est soumis à des vibrations importantes, les coûts de fabrication d'un tel boîtier demeurant faibles. Dans le cas où une des coquilles comporte au moins une fenêtre pour le passage à son travers d'un connecteur dont est pourvu le dispositif électronique, il est aussi visé par la présente invention de préserver les connecteurs d'un risque de désalignement du connecteur vis-à-vis de la fenêtre et/ou d'un risque de détérioration du connecteur, notamment lors de l'assemblage du dispositif électronique à l'intérieur du boîtier de protection.

Le boîtier de la présente invention est un boîtier de protection d'un dispositif électronique destiné à équiper un véhicule automobile. Le boîtier comprend une pluralité de coquilles assemblées entre elles.

Selon la présente invention, au moins une première coquille est formée d'au moins deux coquilles élémentaires et ladite première coquille intègre de moulage au moins un moyen de mobilité des coquilles élémentaires l'une par rapport à l'autre.

Ces dispositions sont telles que les coquilles élémentaires constitutives de la première coquille sont mobiles l'une par rapport à l'autre pour faciliter l'assemblage entre elles de la première coquille et d'au moins une deuxième coquille. Il ressort encore de ces dispositions que des vibrations mécaniques et/ou des dilatations différentielles auxquelles un tel boîtier est susceptible d'être soumis sont sans effet sur l'assemblage des coquilles entre elles, grâce au moyen de mobilité des coquilles élémentaires entre elles. Un tel moyen permet un déplacement relatif d'une coquille élémentaire par rapport à une autre coquille élémentaire pour amortir et/ou compenser de telles vibrations et/ou de telles dilatations.

Dans le cas particulier où la première coquille est pourvue d'une fenêtre pour le passage à son travers d'un connecteur électrique solidaire du dispositif électronique, l'assemblage des coquilles entre elles se trouve facilité. En effet, lors de l'assemblage de la première coquille avec la deuxième coquille, un alignement de la fenêtre en vis-à-vis du connecteur est obtenu si nécessaire à partir de la mise en oeuvre du moyen de mobilité. Il résulte aussi de ces dispositions qu'une dilatation thermique différentielle du dispositif électronique et de la première coquille est compensée par une sollicitation du moyen de mobilité. Cette compensation permet de préserver le connecteur d'efforts internes conséquents appliqués par la première coquille sur le connecteur et d'éviter sa détérioration. De même, les vibrations auxquelles le boîtier de protection est susceptible d'être soumis n'affectent pas le connecteur électrique, à partir de la mise en oeuvre dudit moyen de mobilité.

Il résulte encore de ces dispositions que la première coquille et le moyen de mobilité sont réalisés simultanément, cette réalisation étant obtenue sans adjonction d'une quelconque pièce supplémentaire et sans surcoût de fabrication par rapport à une première coquille exempte d'un tel moyen.

Il résulte enfin de ces dispositions que la première coquille et le moyen de mobilité peuvent être obtenus par moulage d'une matière plastique peu onéreuse, telle qu'un polycarbonate chargé en talc, nonobstant un retrait aléatoire de la première coquille lors de sa fabrication, ce retrait étant susceptible d'être aisément et spontanément compensé par une déformation de l'organe élastiquement déformable.

La première coquille est avantageusement formée d'une seule pièce. Il en découle que les coquilles élémentaires et le moyen de mobilité constitue un ensemble monobloc, unitaire, les coquilles élémentaires et le moyen de mobilité étant solidaires les uns des autres. Ces dispositions sont telles que la première coquille est aisément manipulable par un opérateur pour son assemblage à la deuxième coquille notamment. Le caractère monobloc de la première coquille lui confère une facilité de manipulation sans affecter son intégrité structurelle.

Ledit moyen de mobilité comprend préférentiellement un organe élastiquement déformable. Un tel organe élastiquement déformable est apte à changer de conformation sous l'effet d'efforts qui lui sont appliqués et à retrouver sa conformation initiale lorsque de tels efforts ne lui sont plus appliqués, sans que son intégrité structurelle soit affectée. Une telle modification de conformation est susceptible d'être effectuée à de nombreuses reprises, le retour à la conformation initiale étant à chaque fois obtenu de manière satisfaisante.

L'organe élastiquement déformable comprend avantageusement au moins un pli ménagé entre les coquilles élémentaires.

Le pli est préférentiellement conformé en oméga « Ω ». Un tel pli est notamment conformé en un pontet à bords rabattus. Un tel pli est aisément réalisable par moulage conjointement avec les coquilles élémentaires qu'il sépare l'une de l'autre.

Le moyen de mobilité est avantageusement placé au tiers d'une longueur L de la première coquille. Ces dispositions sont telles qu'une telle première coquille est aisément manipulable à partir de sa préhension au moyen de la coquille élémentaire formée des deux tiers de la première coquille. En effet, la coquille élémentaire formée du tiers de la première coquille ne tend pas à se replier contre l'autre coquille élémentaire, sous l'effet de son propre poids et à partir d'une déformation excessive du pli. Il en ressort finalement une facilité et une rapidité d'assemblage des coquilles entre elles.

De préférence, les coquilles élémentaires sont pourvues d'organes respectifs de butée antagoniste à l'encontre d'un écrasement du pli. De telles dispositions confortent l'aisance de manipulation de la première coquille à partir d'un empêchement d'un écrasement excessif du pli.

D'une manière générale, il ressort de ces dispositions que l'organe élastiquement déformable confère à la première coquille une mobilité des coquilles élémentaires l'une par rapport à l'autre, la disposition du pli au tiers de la longueur L et les organes de butée antagoniste conférant à la première coquille un maintien des coquilles élémentaires l'une par rapport à l'autre. Ces dispositions constituent un compromis entre l'obtention d'une première coquille élastiquement déformable, cette déformabilité n'étant toutefois pas excessive au regard d'une impossibilité de manipulation aisée de la première coquille, voire d'un écrasement excessif de l'organe élastiquement déformable pouvant permettre une détérioration du dispositif électronique.

Une aile de rigidification est préférentiellement ménagée en prolongement de l'organe de butée antagoniste correspondant. Ces dispositions visent à conforter l'intégrité structurelle des organes de butée qui sont susceptibles de se déformer au fur et à mesure de leur mise en oeuvre.

L'organe élastiquement déformable est préférentiellement ménagé dans une paroi de fond de la première coquille. Une telle paroi de fond couvrant avantageusement le dispositif électronique pour le protéger, ces dispositions visent à faciliter la mobilité des coquilles élémentaires l'une par rapport à l'autre dans un plan dans lequel s'étend les coquilles élémentaires.

De préférence, l'organe élastiquement déformable est également ménagé dans une paroi de bordure de la première coquille. Pour éviter une distorsion de la mobilité des coquilles élémentaires l'une par rapport à l'autre, une paroi de bordure ménagée à la périphérie de la paroi de fond comporte également un organe élastiquement déformable préférentiellement ménagé dans un plan identique à celui dans lequel est ménagé l'organe élastiquement déformable de la paroi de fond.

La paroi de bordure comprenant au moins deux bords en vis-à-vis l'un de l'autre, un premier bord comporte de préférence un premier pli qui est ménagé en vis-à-vis d'un deuxième pli du deuxième bord.

L'épaisseur du pli est préférentiellement comprise entre 60% et 85% de l'épaisseur de la paroi dans laquelle il est ménagé. Il ressort de ces dispositions que le pli est aisément réalisable à partir d'un affaiblissement de l'épaisseur de la paroi qui le comporte. Une telle réduction d'épaisseur est notamment facilement réalisable à partir de l'obtention de la première coquille par moulage.

Les plis étant en pluralité, deux plis successifs sont positionnés tête-bêche l'un par rapport à l'autre. Le positionnement tête-bêche de deux plis successifs contribue à empêcher une déformation excessive de la première coquille à partir d'un étirement et/ou d'une élongation important du pli.

Le dispositif électronique est préférentiellement une carte électronique pour commander la mise en oeuvre d'une installation de ventilation, de chauffage et/ou de climatisation.

Sans déroger aux règles de l'invention qui viennent d'être énoncées, on notera que le dispositif électronique est susceptible d'être un dispositif relativement quelconque, tel qu'un auto-radio, un compteur d'affichage d'un paramètre de fonctionnement du véhicule ou analogue.

### Description des figures.

La présente invention sera mieux comprise, et des détails en relevant apparaîtront, à la lecture de la description qui va être faite de variantes de réalisation en relation avec les figures des planches annexées, dans lesquelles :
La fig.1 est une vue schématique en perspective éclatée d'un boîtier de protection selon la présente invention.
La fig.2 est une vue schématique en perspective d'un capot arrière constitutif du boîtier illustré sur la figure précédente, ce capot arrière étant réalisé selon une première variante de réalisation.
La fig.3 est une vue schématique de face du capot arrière illustré sur la figure précédente.
La fig.4 est une vue schématique partielle en coupe du capot arrière illustré sur les fig.2 et fig.3.
La fig.5 est une vue schématique de face d'un capot arrière selon une deuxième variante de réalisation de la présente invention.
La fig.6 est une vue schématique en perspective d'un capot arrière selon une troisième variante de réalisation de la présente invention.

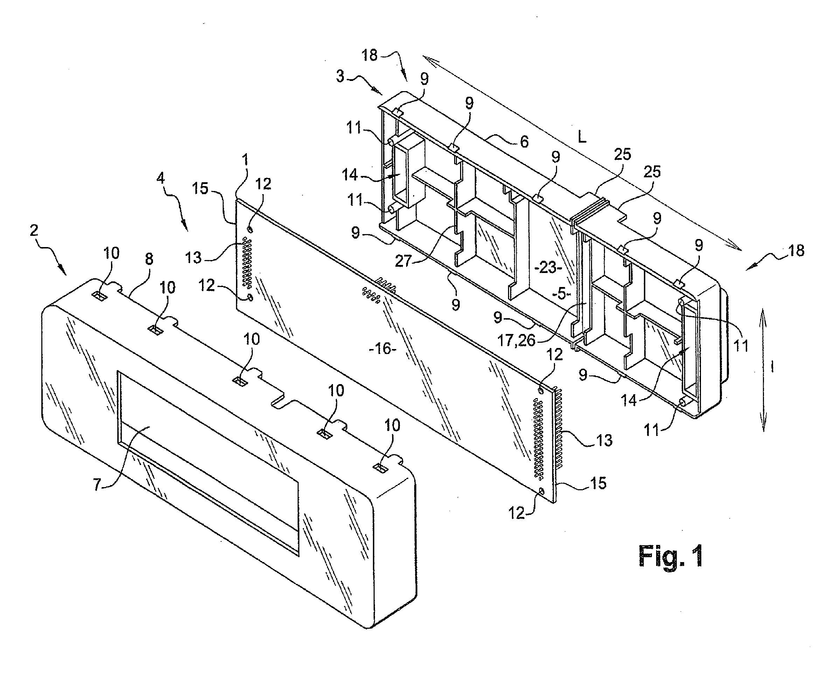

Sur la fig.1, un boîtier de protection loge un dispositif électronique 1, tel qu'une carte électronique pour commander la mise en oeuvre d'une installation de ventilation, de chauffage et/ou de climatisation d'un véhicule automobile. Le boîtier est principalement constitué d'une façade avant 2 et d'un capot arrière 3 qui sont assemblés l'un à l'autre pour délimiter conjointement une enceinte 4 à l'intérieur de laquelle est logée la carte électronique 1. La façade avant 2 comporte une face avant 7 accessible à un utilisateur qui est bordée par une paroi périphérique 8. Le capot arrière 3 comporte quant à lui une paroi de fond 5 en périphérie de laquelle est ménagée une paroi de bordure 6. La paroi de fond 5 est d'une conformation sensiblement rectangulaire en s'étendant selon une longueur L et une largeur l. La paroi de fond 5 est équipée de nervures 27 agencées en croisillon qui constituent des éléments de rigidification de la paroi de fond 5. Ces nervures 27 constituent également des éléments de support de la carte électronique 1 à l'intérieur de l'enceinte 4.

Lors de la mise en place de la carte électronique 1 à l'intérieur de l'enceinte 4, la carte électronique 1 est dans un premier temps rapportée sur la façade avant 2 par l'intermédiaire de moyens de fixation, du type par clipage ou analogue. Le capot arrière 3 est ensuite rapporté simultanément sur la façade avant 2 et sur la carte électronique 1, jusqu'à ce que la carte électronique 1, ou des composants qu'elle porte, vienne en butée contre les nervures 27.

La paroi de bordure 6 est équipée d'ergots 9 qui coopèrent par emboîtement avec des saignées 10 ménagées à travers la paroi périphérique 8. La paroi de fond 5 est équipée de doigts d'emboîtement 11 qui coopèrent avec des orifices respectifs 12 ménagés à travers la carte électronique 1. De tels doigts d'emboîtement 11 permettent de positionner précisément le capot arrière 3 vis-à-vis de la carte électronique 1, lors de la mise en place du capot arrière 3 sur la carte électronique 1.

Pour permettre une liaison électrique entre la carte électronique 1 et des éléments distants de l'installation de ventilation, de chauffage et/ou de climatisation, la carte électronique 1 est équipée de connecteurs 13, éventuellement formés de rangées de broches. La paroi de fond 5 est pourvue de fenêtres 14 pour le passage et/ou la réception des connecteurs 13. Il est courant dans le domaine de placer les connecteurs 13 sur la carte électronique 1 à distance les uns des autres, et plus particulièrement le long de deux bords distants 15 opposés de la carte électronique 1. Ces dispositions permettent de laisser libre une zone centrale 16 de la carte électronique 1 pour des composants électroniques essentiels qu'elle comporte, microprocesseur notamment.

Lors de la mise en place de la carte électronique 1 à l'intérieur de l'enceinte 4, se pose donc le problème d'un triple positionnement, à savoir celui du capot arrière 3 par rapport à la façade avant 2, celui du capot arrière 3 par rapport à la carte électronique 1 et celui de cette dernière 1 par rapport à la façade avant 2. Pour permettre un alignement des connecteurs 13 de la carte électronique 1 en vis-à-vis des fenêtres 14 du capot arrière 3, ce dernier 3 intègre de moulage au moins un pli 17 qui constitue un organe élastiquement déformable 26 du capot arrière 3. On comprendra que le pli 17 est formé par moulage simultanément avec le capot arrière 3, de sorte que le pli 17 et le capot arrière 3 constituent une seule pièce monobloc, notamment réalisée en matière plastique. On comprendra aussi que l'organe élastiquement déformable 26 constitue un moyen pour faire varier les dimensions de la paroi de fond 5, à savoir sa longueur L dans l'exemple illustré. Le caractère élastiquement déformable d'un tel organe 26 est obtenue, soit à partir d'une réduction de l'épaisseur de la paroi de fond 5, notamment une réduction de 60% à 85%, soit à partir de la réalisation d'un capot arrière 3 avec deux matières plastiques différentes. Dans ce cas, une première matière plastique rigide permet la mise en forme de coquilles élémentaires 18 constitutives de la paroi de fond tandis que le pli 17 est réalisé à partir d'une deuxième matière plastique, plus souple que la première. La réalisation d'un tel capot arrière 3 bi-matière est aisément réalisable par moulage en une seule étape.

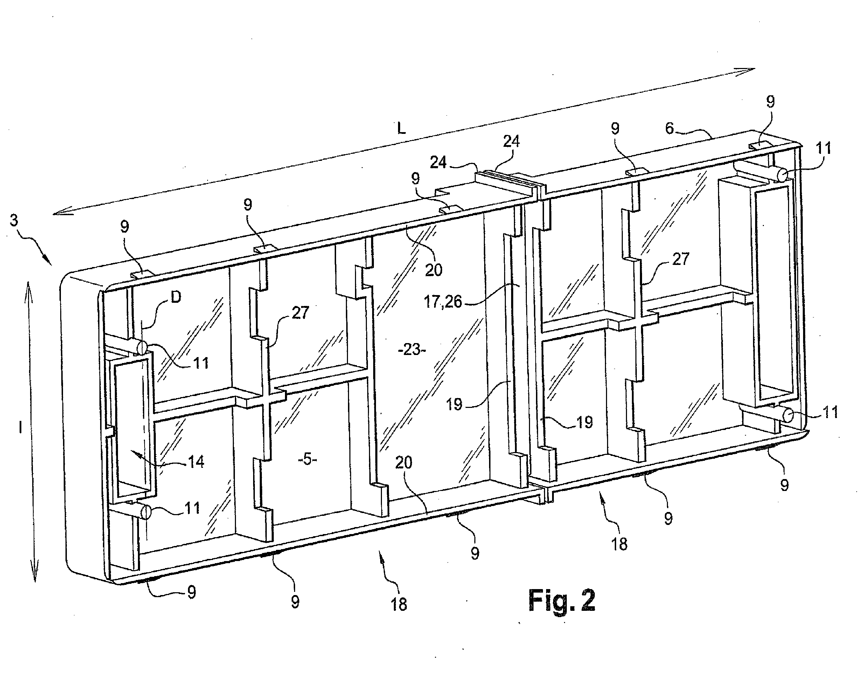

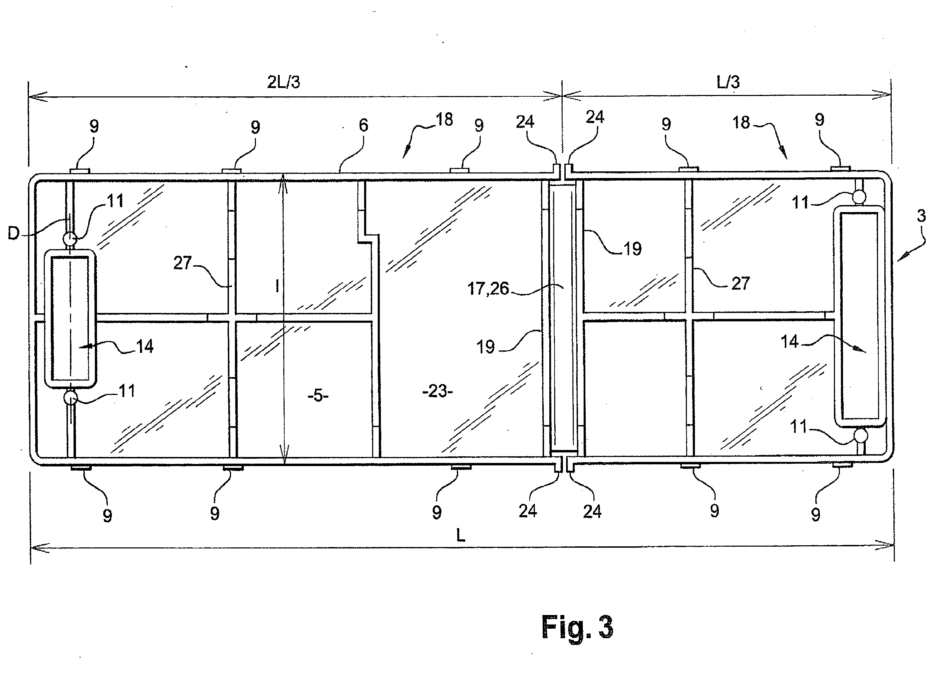

Sur les fig.2 et fig.3, le pli 17 est unique et est ménagé dans la paroi de fond 5 parallèlement à la direction générale d'extension D des fenêtres 14. La direction D est parallèle à la direction de la largeur l de la paroi de fond 5. Le pli 17 divise le capot arrière 3 en deux coquilles élémentaires 18 qui comportent chacune une fenêtre 14. Plus particulièrement, le pli 17 sépare la paroi de fond en deux coquilles élémentaires 18 de dimension différente, et notamment de longueur différente. Selon une forme préférée de réalisation de la présente invention, la longueur d'une coquille élémentaire 18 est de l'ordre du double de la longueur de l'autre coquille élémentaire 18. Ces dispositions permettent de laisser libre un espace central 23 du capot arrière 3, pour loger notamment un microprocesseur porté par la carte électronique 1.

Le pli 17 permet une mobilité relative des coquilles élémentaires 18 l'une par rapport à l'autre. Le pli 17 est ménagé entre deux platines 19 respectivement solidaires des coquilles élémentaires 18. Les platines 19 sont ménagées orthogonalement à la paroi de fond 5 et s'étendent entre deux bords opposés 20 de la paroi de bordure 6. De telles platines 19 constituent des renforts structurels de la paroi de fond 5 contre lesquels renforts la carte électronique 1 est également susceptible de venir en butée lorsque la carte électronique 1 est mise en place à l'intérieur de l'enceinte 4. On notera que le pli 17 s'étend sur toute la largeur L du capot arrière 3.

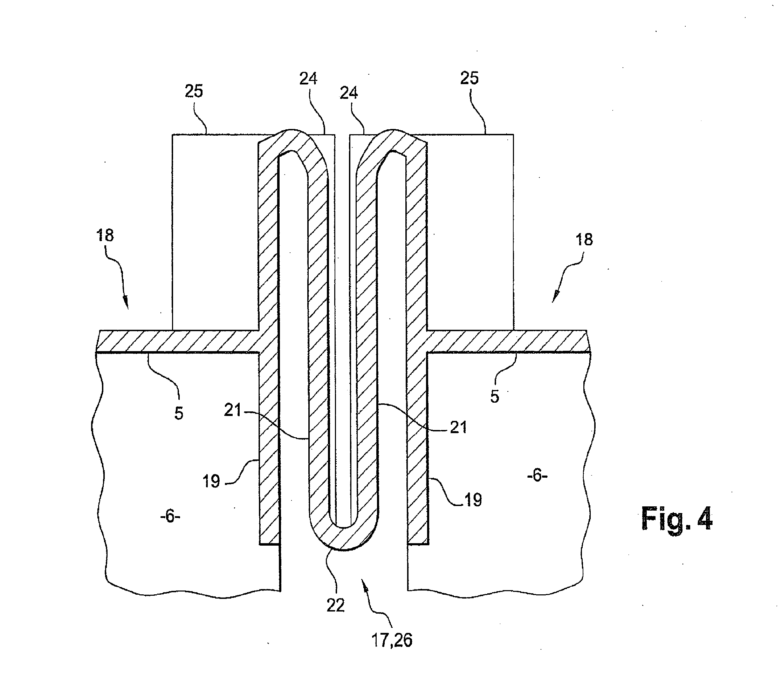

Sur la fig.4, le pli 17 est conformé en oméga « Ω » comportant deux jambes 21 respectivement reliées à la platine 19 de la coquille élémentaire correspondante 18, les jambes 21 d'un pli 17 étant reliées entre elles par un sommet 22 du pli 17. Selon une autre variante de réalisation de la présente invention, les jambes 21 du pli 17 sont reliées directement à la paroi de fond 5.

Chaque coquille élémentaire 18 est équipée d'organes de butée antagoniste 24 à l'encontre de l'écrasement du pli 17. De tels organes de butée 24 permettent de limiter l'écrasement du pli 17 sur lui-même, pour éviter une déformation trop importante du capot arrière 3, qui serait susceptible d'empêcher l'assemblage du capot arrière 3 sur la façade avant 2 et/ou sur la carte électronique 1. En effet, lorsque des efforts conséquents sont appliqués au capot arrière 3 pour écraser le pli 17, les organes de butée antagoniste 24 sont en contact l'un avec l'autre de telle sorte que la déformation du capot arrière 3 se trouve contenue dans des proportions contrôlées, qui permettent d'éviter une impossibilité à utiliser le capot arrière 3 ou une détérioration de ce dernier 3.

Selon la variante de réalisation illustrée sur la fig.2, chaque organe de butée 24 est constitué d'un retour de la paroi de bordure 6 d'une coquille élémentaire 18 qui est ménagé orthogonalement à la paroi de bordure 6 et qui est disposé en vis-à-vis d'un retour antagoniste ménagé dans la paroi de bordure 6 de l'autre coquille élémentaire 18.

Sur la fig.3, chaque organe de butée 24 est constitué d'une extension de la paroi de bordure 6 d'une coquille élémentaire 18 en direction de la paroi de bordure 6 de l'autre coquille élémentaire 18.

Sur la fig.4, chaque organe de butée 24 est pourvu d'une aile de rigidification 25 qui est constituée d'un prolongement de la paroi de bordure 6.

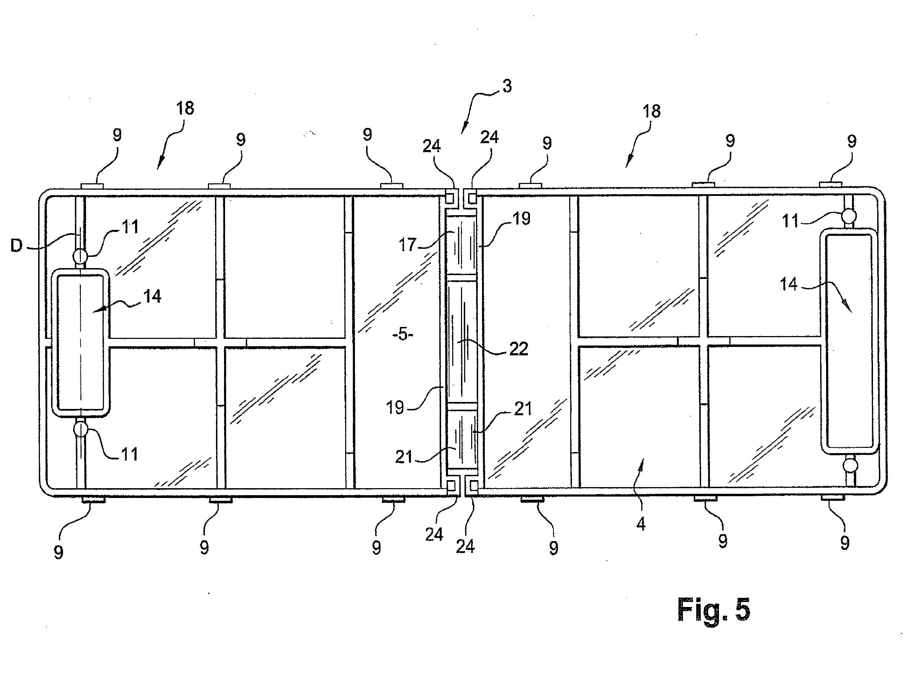

Selon la deuxième variante de réalisation illustrée sur la fig.5, les plis 17 sont en pluralité et sont ménagés dans la paroi de fond 5 du capot arrière 3. Plus précisément, la paroi de fond 5 comporte trois plis successifs 17 qui sont alignés selon une même direction parallèle à la direction générale d'extension D des fenêtres 14. Deux plis successifs 17 sont positionnés tête-bêche l'un par rapport à l'autre, de sorte que le sommet 22 d'un premier pli 17 est orienté vers l'enceinte 4 tandis que le sommet 22 d'un deuxième pli successif 17 est orienté vers l'extérieur du capot arrière 3. Chaque organe de butée 24 est constitué d'un prolongement de la paroi de bordure 6 qui est ménagé à l'intersection de la paroi de bordure 6 et de la platine correspondante 19.

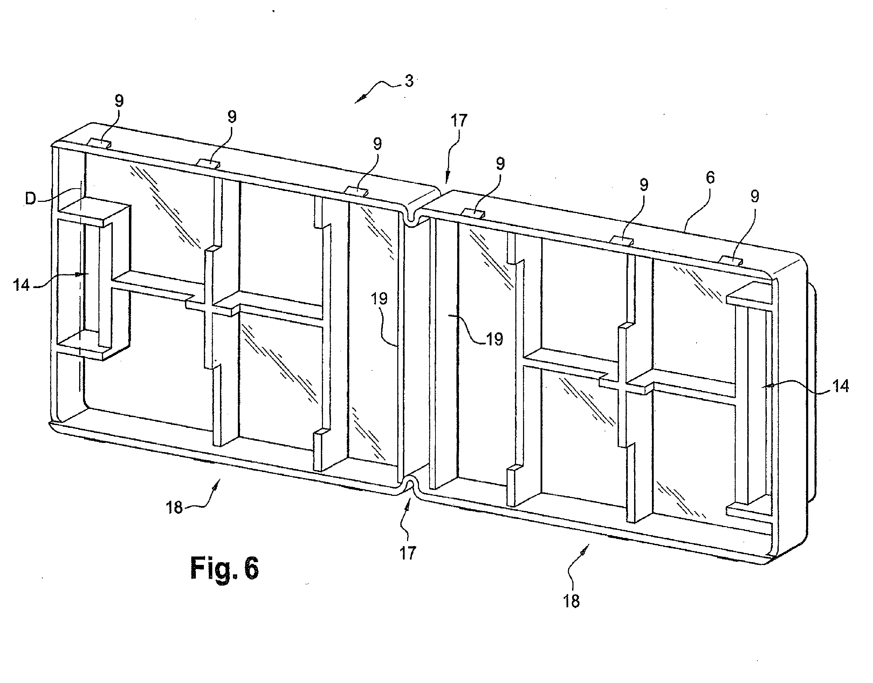

Selon la troisième variante de réalisation illustrée sur la fig.6, les plis 17 sont en pluralité et sont ménagés dans la paroi de bordure 6 du capot arrière 3. Plus particulièrement, les plis 17 sont au nombre de deux et sont ménagés en vis-à-vis l'un de l'autre dans deux bords opposés 20 de la paroi de bordure 6.

## Revendications

1. Boîtier de protection d'un dispositif électronique (1) destiné à équiper un véhicule automobile, le boîtier comprenant une pluralité de coquilles (2,3) formant une façade (2) et un capot (3) assemblées entre elles pour délimiter conjointement une enceinte (4) à l'intérieur de laquelle est destiné à être logée une carte électronique (1) munie de connecteurs (13) distants, dans lequel au moins une première coquille (3) est formée d'au moins deux coquilles élémentaires (18) disposées côte à côte et ladite première coquille (3) intègre de moulage au moins un moyen de mobilité des coquilles élémentaires l'une par rapport à l'autre et ledit moyen de mobilité comprend un organe élastiquement déformable (26), **caractérisé en ce que** la première coquille (3) est formée d'une seule pièce, **en ce que** les deux coquilles élémentaires (18) comportent chacune une fenêtre pour le passage et/ou de réception d'un connecteur (13).

2. Boîtier selon la revendication 1, **caractérisé en ce que** l'organe élastiquement déformable (26) comprend au moins un pli (17) ménagé entre les coquilles élémentaires (18).

3. Boîtier selon la revendication 2, **caractérisé en ce que** le pli (17) est conformé en oméga « Ω ».

4. Boîtier selon l'une quelconque des revendications précédentes, **caractérisé en ce que** le moyen de mobilité est placé au tiers d'une longueur L de la première coquille (3).

5. Boîtier selon l'une quelconque des revendications 2 à 4, **caractérisé en ce que** les coquilles élémentaires (18) sont pourvues d'organes respectifs de butée antagoniste (24) à l'encontre d'un écrasement du pli (17).

6. Boîtier selon la revendication 5, **caractérisé en ce qu'**une aile de rigidification (25) est ménagée en prolongement de l'organe de butée antagoniste (24) correspondant.

7. Boîtier selon l'une quelconque des revendications précédentes, **caractérisé en ce que** l'organe élastiquement déformable (26) est ménagé dans une paroi de fond (5) de la première coquille (3).

8. Boîtier selon l'une quelconque des revendications précédentes, **caractérisé en ce que** l'organe élastiquement déformable (26) est également ménagé dans une paroi de bordure (6) de la première coquille (3).

9. Boîtier selon la revendication 8, **caractérisé en ce que** la paroi de bordure (6) comprenant au moins deux bords (20) en vis-à-vis l'un de l'autre, un premier bord (20) comporte un premier pli (17) qui est ménagé en vis-à-vis d'un deuxième pli (17) du deuxième bord (20).

10. Boîtier selon l'une quelconque des revendications 2 à 9, **caractérisé en ce que** l'épaisseur du pli (17) est comprise entre 60% et 85% de l'épaisseur de la paroi (5,6) dans laquelle il est ménagé.

11. Boîtier selon l'une quelconque des revendications 2 à 10, **caractérisé en ce que** les plis (17) étant en pluralité, deux plis successifs (17) sont positionnés tête-bêche l'un par rapport à l'autre.

12. Boîtier selon l'une quelconque des revendications précédentes, **caractérisé en ce que** le dispositif électronique (1) est une carte électronique pour commander la mise en oeuvre d'une installation de ventilation, de chauffage et/ou de climatisation.

## Patentansprüche

1. Schutzgehäuse einer elektronischen Vorrichtung (1), die zur Ausrüstung eines Kraftfahrzeugs bestimmt ist, wobei das Gehäuse eine Vielzahl von eine Frontseite (2) und einen Deckel (3) bildenden Schalen (2, 3) enthält, die zusammengefügt werden, um zusammen einen Raum (4) zu begrenzen, in dessen Innerem eine mit entfernten Verbindern (13) versehene Elektronikkarte (1) untergebracht werden soll, wobei mindestens eine erste Schale (3) von mindestens zwei nebeneinander angeordneten Elementarschalen (18) gebildet wird, und die erste Schale (3) mindestens eine angeformte Beweglichkeitseinrichtung der Elementarschalen zueinander umfasst, und die Beweglichkeitseinrichtung ein elastisch verformbares Organ (26) enthält, **dadurch gekennzeichnet, dass** die erste Schale (3) aus einem Stück geformt ist, und dass die zwei Elementarschalen (18) je ein Fenster für den Durchgang und/oder die Aufnahme eines Verbinders (13) aufweisen.

2. Gehäuse nach Anspruch 1, **dadurch gekennzeichnet, dass** das elastisch verformbare Organ (26) mindestens einen zwischen den Elementarschalen (18) angeordneten Knick (17) enthält.

3. Gehäuse nach Anspruch 2, **dadurch gekennzeichnet, dass** der Knick (17) die Form eines Omega « Q » hat.

4. Gehäuse nach einem der vorhergehenden Ansprüche, **dadurch gekennzeichnet, dass** die Beweglichkeitseinrichtung im Drittel einer Länge L der ersten Schale (3) angeordnet ist.

5. Gehäuse nach einem der Ansprüche 2 bis 4, **dadurch gekennzeichnet, dass** die Elementarschalen (18) je mit einem Zusammenquetschen des Knicks (17) entgegenwirkenden Anschlagorganen (24) versehen sind.

6. Gehäuse nach Anspruch 5, **dadurch gekennzeichnet, dass** ein Versteifungsflügel (25) in der Verlängerung des entsprechenden entgegenwirkenden Anschlagorgans (24) angeordnet ist.

7. Gehäuse nach einem der vorhergehenden Ansprüche, **dadurch gekennzeichnet, dass** das elastisch verformbare Organ (26) in einer Bodenwand (5) der ersten Schale (3) angeordnet ist.

8. Gehäuse nach einem der vorhergehenden Ansprüche, **dadurch gekennzeichnet, dass** das elastisch verformbare Organ (26) ebenfalls in einer Umrandungswand (6) der ersten Schale (3) angeordnet ist.

9. Gehäuse nach Anspruch 8, **dadurch gekennzeichnet, dass**, da die Umrandungswand (6) mindestens zwei einander gegenüberliegende Ränder (20) enthält, ein erster Rand (20) einen ersten Knick (17) aufweist, der gegenüber einem zweiten Knick (17) des zweiten Rands (20) angeordnet ist.

10. Gehäuse nach einem der Ansprüche 2 bis 9, **dadurch gekennzeichnet, dass** die Dicke des Knicks (17) zwischen 60% und 85% der Dicke der Wand (5, 6) liegt, in der er angeordnet ist.

11. Gehäuse nach einem der Ansprüche 2 bis 10, **dadurch gekennzeichnet, dass**, da es eine Vielzahl von Knicken (17) gibt, zwei aufeinanderfolgende Knicke (17) Kopf bei Fuß zueinander positioniert sind.

12. Gehäuse nach einem der vorhergehenden Ansprüche, **dadurch gekennzeichnet, dass** die elektronische Vorrichtung (1) eine Elektronikkarte zum Steuern der Anwendung einer Lüftungs-, Heiz- und/oder Klimaanlage ist.

## Claims

1. Housing for protecting an electronic device (1) to be fitted to a motor vehicle, the housing comprising a plurality of shells (2, 3) forming a front (2) and a cap (3), these being assembled together to define jointly an enclosure (4) for housing an electronic circuit card (1) provided with remote connectors (13), wherein at least one first shell (3) is formed from at least two elementary shells (18) situated side-by-side and said first shell (3) includes, molded into it, at least one mobility means allowing relative movement between the elementary shells and said mobility means comprises an elastically deformable member (26), **characterized in that** the first shell (3) is formed in one piece, and the two elementary shells (18) are situated side-by-side, each comprise a window for the passage and/or reception of a connector (13).

2. Housing according to Claim 1, **characterized in that** the elastically deformable member (26) comprises at least one pleat (17) between the elementary shells (18).

3. Housing according to Claim 2, **characterized in that** the pleat (17) is the shape of the Greek letter omega (Ω).

4. Housing according to any of the preceding claims, **characterized in that** the mobility means are placed one third of the way along a length L of the first shell (3).

5. Housing according to any of Claims 2 to 4, **characterized in that** the elementary shells (18) are provided with respective antagonistic abutment members (24) opposing crushing of the pleat (17).

6. Housing according to Claim 5, **characterized in that** there is a stiffener flange (25) in line with the corresponding antagonistic abutment member (24).

7. Housing according to any of the preceding claims, **characterized in that** the elastically deformable member (26) is part of a back wall (5) of the first shell (3).

8. Housing according to any of the preceding claims, **characterized in that** the elastically deformable member (26) is also part of a border wall (6) of the first shell (3).

9. Housing according to Claim 8, **characterized in that**, the border wall (6) comprising at least two facing edges (20), a first edge (20) includes a first pleat (17) facing a second pleat (17) on the second edge (20).

10. Housing according to any of Claims 2 to 9, **characterized in that** the thickness of the pleat (17) is between 60% and 85% inclusive of the thickness of the wall (5, 6) in which it is formed.

11. Housing according to any of Claims 2 to 10, **characterized in that**, there being a plurality of pleats (17), two successive pleats (17) are positioned head-to-tail relative to each other.

12. Housing according to any of the preceding claims, **characterized in that** the electronic device (1) is an electronic circuit card for controlling the use of a ventilation, heating and/or air conditioning installation.
